# FASCICULE DE BREVET EUROPEEN

(11) **EP 3 274 150 B1**
(45) Date de publication et mention de la délivrance du brevet: **11.03.2020**
(21) Numéro de dépôt: 16718396.1
(22) Date de dépôt: 22.03.2016
(51) Int. Cl.: B29C 49/42, B29C 49/10, B29C 59/14, B29C 49/06, B29C 49/36

(54) **PROCÉDÉ DE FABRICATION D'UN EMBALLAGE COMPRENANT UN RÉCIPIENT IMPRIMÉ DIRECTEMENT ET TRAITÉ PAR PLASMA**
VERFAHREN ZUR HERSTELLUNG EINER VERPACKUNG MIT EINEM DIREKT BEDRUCKTEN UND DURCH PLASMA BEHANDELTEN BEHÄLTER
METHOD FOR MANUFACTURING PACKAGING COMPRISING A CONTAINER PRINTED ON DIRECTLY AND TREATED BY PLASMA

(30) Priorité: 25.03.2015 FR 1552481
(43) Date de publication de la demande: 31.01.2018
(73) Titulaire: Sidel Participations, 76930 Octeville-sur-Mer (FR)
(72) Inventeur: BIANCHINI, Cédric, 76930 Octeville-Sur-Mer (FR); FEUILLOLEY, Guy, 76930 Octeville-Sur-Mer (FR)
(74) Mandataire: Grassin d'Alphonse, Emmanuel Jean Marie
(86) Numéro de dépôt international: PCT/FR2016/050623
(87) Numéro de publication internationale: WO 2016/151231

(56) Documents cités:
- WO-A1-01/62613
- WO-A1-2011/141696
- WO-A2-2014/053708
- US-A1- 2010 206 232

## Description

L'invention a trait à la fabrication des emballages comprenant un récipient sur lequel est rapportée une inscription décorative et/ou informative.

Dans l'alimentaire, l'inscription est classiquement imprimée sur une étiquette elle-même collée sur une face externe du récipient au moyen d'une machine appelée étiqueteuse, cf. par ex. la demande de brevet européen EP 2 828 170 (Sidel).

Dans la cosmétique, il est courant que l'inscription soit directement imprimée sur la face externe du récipient. Il est vrai que les récipients de cosmétiques en matière plastique, qui présentent généralement une face externe lisse, se prêtent plutôt bien à une telle impression. A contrario, de nombreux récipients en plastique dédiés à l'alimentaire s'y prêtent plutôt mal car ils sont en général pourvus de faces externes nervurées destinées à améliorer leur tenue mécanique pour compenser leur faible masse, dictée par des prix de vente très serrés.

La demande de brevet américain US 2013/0269551 (Till Gmbh) propose une machine pour l'impression directe et en polychromie de récipients tels que des bouteilles ou des canettes.

L'impression directe d'inscriptions décoratives sur la face externe d'un récipient procure plusieurs avantages. D'un point de vue économique d'abord, l'impression directe permet de se passer d'étiquette. D'un point de vue esthétique ensuite, l'impression directe laisse découverte la face externe du récipient, d'ordinaire couverte par une étiquette. D'un point de vue pratique enfin, l'impression directe permet de réaliser des inscriptions évolutives, voire personnalisables, tandis que les étiquettes sont généralement pré-imprimées et stockées en masse, ce qui ne laisse aucune place à la personnalisation (ou marketing ciblé).

Cependant, un problème posé par l'impression directe des récipients en plastique dans l'alimentaire est la migration de certains composants des encres au travers de la paroi des récipients, qui peuvent dans certains cas se révéler poreuses. Il en va notamment ainsi du PET (polytéréphtalate d'éthylène), utilisé en masse pour la fabrication des bouteilles destinées aux boissons. Or la plupart des encres et leurs adjuvants incluent des composés chimiques complexes (notamment des molécules aromatiques) qui ne doivent pas être ingérés.

Une solution est d'imprimer les faces externes des récipients au moyen d'encres alimentaires, mais ces encres sont généralement hydrosolubles et risquent d'être effacées ou étalées par la main de l'utilisateur se saisissant du récipient. Une autre solution consiste à employer des encres polymères qui, après avoir été appliquées sous forme fluide, subissent un séchage forcé au moyen d'un rayonnement ultraviolet, ce qui provoque une réticulation du polymère et son durcissement rapide. Toutefois, il se peut que l'exposition aux ultraviolets ne soit pas parfaite. Une partie de l'encre, qui n'a pas subi de réticulation, demeure alors fluide et peut migrer vers l'intérieur du récipient au travers de la paroi.

"Le document US2010-206232 décrit un procédé de fabrication d'un emballage ayant une couche barrière interne. Le document WO2014-053708 décrit une étiquette avec une couche d'impression et une couche barrière. Le document WO2011-141696 décrit un emballage constitué d'une coquille et d'un sac intérieur. Le document WO01-62613 décrit un récipient permettant d'éviter la contamination par des étiquettes.

Un objectif est par conséquent de proposer un emballage incluant un récipient sur la face externe duquel une inscription puisse être imprimée directement sans risque de contamination du contenu.

A cet effet, il est proposé, en premier lieu, un procédé de fabrication d'un emballage selon la revendication 1 et une installation correspondante selon la revendication 7.

La couche barrière forme un obstacle à la migration de composés chimique éventuellement nocifs de l'encre vers l'intérieur du récipient, ce qui préserve son contenu de toute contamination.

Diverses caractéristiques supplémentaires peuvent être prévues dans ce procédé, seules ou en combinaison :
- la couche barrière comprend du carbone amorphe hydrogéné ;
- l'impression est réalisée par pulvérisation ;
- au cours de l'opération d'impression, le récipient est entraîné en rotation ;
- il est prévu, préalablement à l'opération de formage du récipient, une opération de conditionnement thermique de la préforme.

Il est proposé, en deuxième lieu, une installation pour la fabrication d'emballage comprenant chacun un récipient, cette installation comprenant :
- une unité de formage des récipients à partir de préformes en matière plastique ;
- une unité d'impression d'une face externe des récipients ;
- une unité de traitement d'une face interne des récipients, apte à y former une couche barrière mince par dépôt chimique en phase vapeur assisté par plasma, cette unité de traitement étant interposée entre l'unité de formage et l'unité d'impression.

Diverses caractéristiques supplémentaires peuvent être prévues dans cette installation, seules ou en combinaison :
- l'unité de traitement est adjacente à l'unité de formage ;
- l'unité de traitement est adjacente à l'unité d'impression ;
- l'installation comprend en outre une unité de conditionnement thermique des préformes.

D'autres objets et avantages de l'invention apparaîtront à la lumière de la description d'un mode de réalisation, faite ci-après en référence aux dessins annexés dans lesquels :
- la figure 1 est une vue schématique d'une installation pour la fabrication d'emballages à partir de préformes, qui comprend une unité de traitement thermique, une unité de formage, une unité de traitement par plasma et une unité d'impression ;
- la figure 2 est une vue schématique en coupe de l'unité de traitement thermique ;
- la figure 3 est une vue schématique en coupe d'un moule de l'unité de formage ;
- la figure 4 est une vue en coupe d'un poste de l'unité de traitement par plasma ;
- la figure 5 est une vue schématique en coupe de l'unité d'impression ;
- la figure 6 est une vue schématique illustrant le remplissage du récipient au sein d'une unité de remplissage ;
- la figure 7 est une vue schématique illustrant le bouchage du récipient rempli, au sein d'une unité de bouchage ;
- la figure 8 est une vue de l'emballage incluant le récipient pourvu de sa couche barrière, imprimé, rempli et bouché.

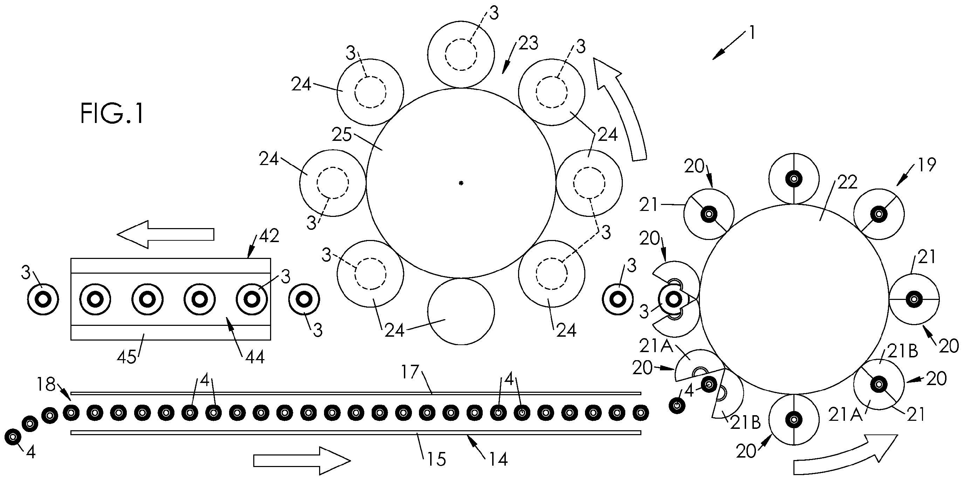

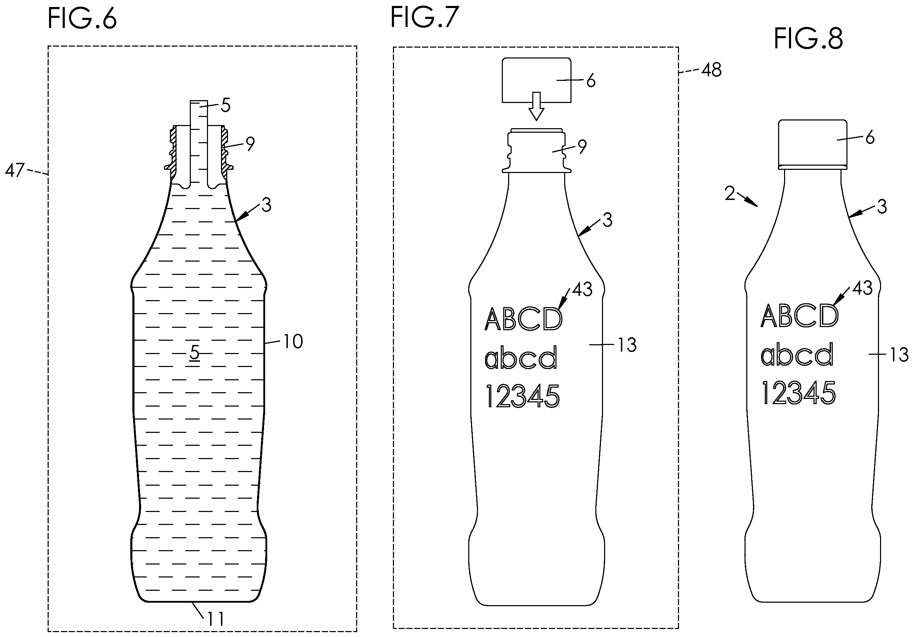

Sur la figure 1 est représentée une installation **1** pour la fabrication d'emballages **2,** chaque emballage **2** (bien visible sur la figure 8) comprenant un récipient **3** formé à partir d'une préforme **4** en matière plastique, un produit **5** (notamment liquide, pâteux ou pulvérulent) contenu dans le récipient **3,** et un bouchon **6** fermant le récipient **3.**

La matière plastique dans laquelle est réalisée chaque préforme **4** peut être un polyester, notamment du PET (polytéréphtalate d'éthylène), qui offre une bonne rigidité mécanique tout en ayant de bonnes qualités de transparence.

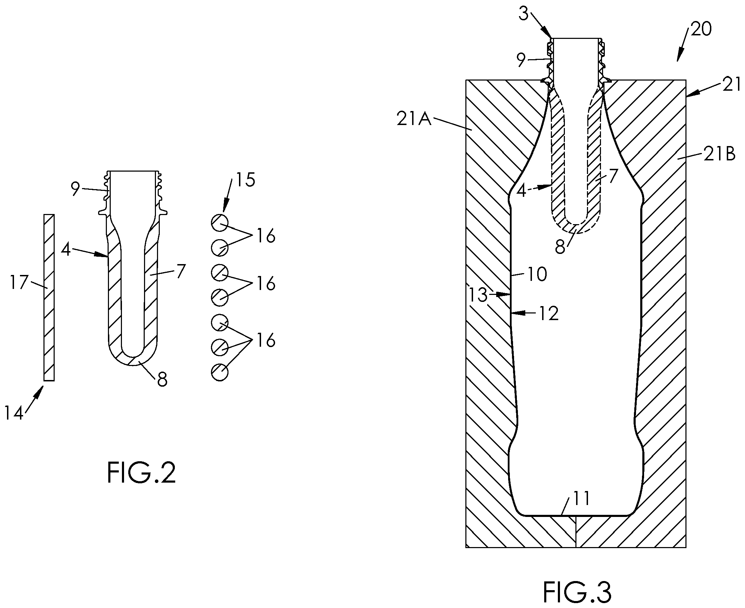

Une préforme **4** est schématiquement illustrée sur la figure 2. Elle comprend un corps **7** globalement cylindrique, un fond **8** hémisphérique qui ferme le corps **7** à une extrémité inférieure, et un col **9** ouvert qui prolonge le corps **7** à une extrémité supérieure. Le col **9** présente sa forme finale et demeure inchangé au cours du formage du récipient **3.**

Le récipient **3** formé à partir de la préforme **4** est illustré en coupe sur la figure 3. Il comprend une paroi **10** latérale issue du corps **7** de la préforme, un fond **11** issu du fond **8** de la préforme **4** et qui s'étend à partir d'une extrémité inférieure de la paroi **10** latérale, et le col **9** qui s'étend à partir d'une extrémité supérieure de la paroi **10** latérale. Le récipient **3** présente une face **12** interne, qui délimite le volume intérieur du récipient **3,** destiné à accueillir le produit **5,** et une face **13** externe opposée, par laquelle le récipient **3** est destiné à être manipulé par un utilisateur.

L'installation **1** comprend, en premier lieu, une unité **14** de conditionnement thermique des préformes **4.** L'unité **14** de conditionnement thermique comprend au moins une paroi **15** rayonnante munie de sources **16** de rayonnement et, le cas échéant, au moins une paroi **17** réfléchissante placée en regard de la paroi **15** rayonnante. Les sources **16** émettent dans un domaine du spectre électromagnétique susceptible de provoquer la chauffe des préformes **4.** Il peut notamment s'agir du domaine des microondes, ou encore du domaine infrarouge. Les sources **16** peuvent être des lampes halogènes émettant dans l'infrarouge, ou encore des lasers (par exemple des diodes, typiquement des diodes VCSEL).

En fonctionnement normal (c'est-à-dire en production de série), les préformes **4** sont introduites à température ambiante dans l'unité **14** de conditionnement thermique par une entrée **18** de celle-ci, par exemple au moyen d'une roue ou d'un convoyeur d'alimentation. Puis les préformes **4** sont chauffées au défilé dans l'unité **14** de conditionnement thermique à une température supérieure à la température de transition vitreuse de la matière (la température finale des préformes **4** à la sortie de l'unité **14** de conditionnement thermique est par exemple de l'ordre de 120°C pour le PET, dont la température de transition vitreuse est d'environ 80°C).

Dans l'unité **14** de conditionnement thermique, chaque préforme **4** est avantageusement montée sur un support pivotant appelé tournette, de sorte à exposer l'ensemble du corps **7** et du fond **8** au rayonnement des sources **16.** Dans l'exemple illustré sur la figure 2, les préformes **4** sont convoyées col en haut dans l'unité **14** de conditionnement thermique, mais elles pourraient être convoyées col en bas. Pour évacuer au moins une partie de la chaleur excédentaire produite par la paroi **15** rayonnante ou rayonnée par les préformes **4** elles-mêmes, l'unité **14** de conditionnement thermique peut être équipée d'un système de ventilation positionné au droit du col **9,** qui doit demeurer à une température proche de la température ambiante.

L'installation **1** comprend, en deuxième lieu, une unité **19** de formage des récipients **3** par soufflage ou étirage soufflage à partir des préformes **4** issues de l'unité **14** de conditionnement thermique. Comme on le voit sur la figure 1, l'unité **19** de formage est située en aval de l'unité **14** de conditionnement thermique (les flèches illustrent le sens de déplacement des préformes **4** puis des récipients **3** au sein de l'installation **b**). Plus précisément, dans l'exemple illustré, l'unité **19** de formage est adjacente à l'unité **14** de conditionnement thermique. Compte tenu de la vitesse de défilement des préformes **4** (pour une production de plusieurs dizaines de milliers de récipients **3** par heure), les préformes **4** n'ont pas le temps de refroidir entre la sortie de l'unité **14** de conditionnement thermique et l'entrée de l'unité **19** de formage. En d'autres termes, le profil thermique des préformes **4** à l'entrée de l'unité **19** de formage est sensiblement identique à celui qu'elles présentent à la sortie de l'unité **14** de conditionnement thermique.

L'unité **19** de formage est équipée d'au moins un poste **20** (et en l'espèce une série de postes **20**) de formage, chacun muni d'un moule **21** à l'empreinte du modèle de récipient à former.

Selon un mode de réalisation illustré sur la figure 1, l'unité **19** de formage comprend un carrousel **22** tournant sur lequel sont montés les postes **20** de formage.

Chaque poste **20** de formage est équipé d'un dispositif d'injection, dans la préforme **4,** d'un gaz (notamment de l'air) sous pression (entre 5 bars et 30 bars environ). Selon un mode de réalisation correspondant à un procédé de formage par étirage soufflage, chaque poste **20** de formage est en outre équipé d'une tige d'étirage mobile en translation par rapport au moule **21.**

Dans l'exemple illustré, le moule **21** est du type portefeuille et comprend deux demi-moules **21A, 21B** montés articulés l'un par rapport à l'autre entre une position ouverte (visible sur la figure 1) dans laquelle les demi-moules **21A, 21B** sont angulairement écartés l'un de l'autre pour permettre l'introduction d'une préforme **4** issue de l'unité **14** de conditionnement thermique, et une position fermée (également visible sur la figure 1 ainsi que sur la figure 3) dans laquelle les demi-moules **21A, 21B** sont appliqués l'un contre l'autre pour former ensemble l'empreinte du récipient **3** à former.

L'installation **1** comprend, en troisième lieu, une unité **23** de traitement des récipients **3** par plasma, qui est avantageusement adjacente à l'unité **19** de formage. Plus précisément, l'unité **23** de traitement est agencée pour réaliser le dépôt chimique en phase vapeur assisté par plasma, sur la face **12** interne de chaque récipient **3** issu de l'unité **19** de formage, d'une couche barrière mince.

Cette couche peut être composée de carbone amorphe hydrogéné (a-C:H), qui présente l'avantage de former une barrière à de nombreuses molécules avec lesquelles la face **13** externe du récipient **3** est en contact, et auxquelles la matière (par ex. le PET) peut se révéler perméable. D'autres types de couches minces que celles à base de carbone peuvent convenir, notamment à base d'oxyde de silicium ou d'aluminium.

L'unité **23** de traitement par plasma comprend un (ou, comme dans l'exemple illustré, plusieurs) poste(s) **24** de traitement plasma, configuré(s) pour accueillir et traiter un récipient **3** à la fois. Dans l'exemple illustré, l'unité **23** de traitement comprend une série de postes **24** de traitement tous identiques, et une structure **25** tournante (tel qu'un carrousel) sur laquelle sont montés les postes **24** de traitement, qui sont par ex. au nombre de vingt-quatre, ou encore de quarante-huit, de sorte à permettre un traitement plasma des récipients **3** à cadence industrielle (plusieurs dizaines de milliers par heure).

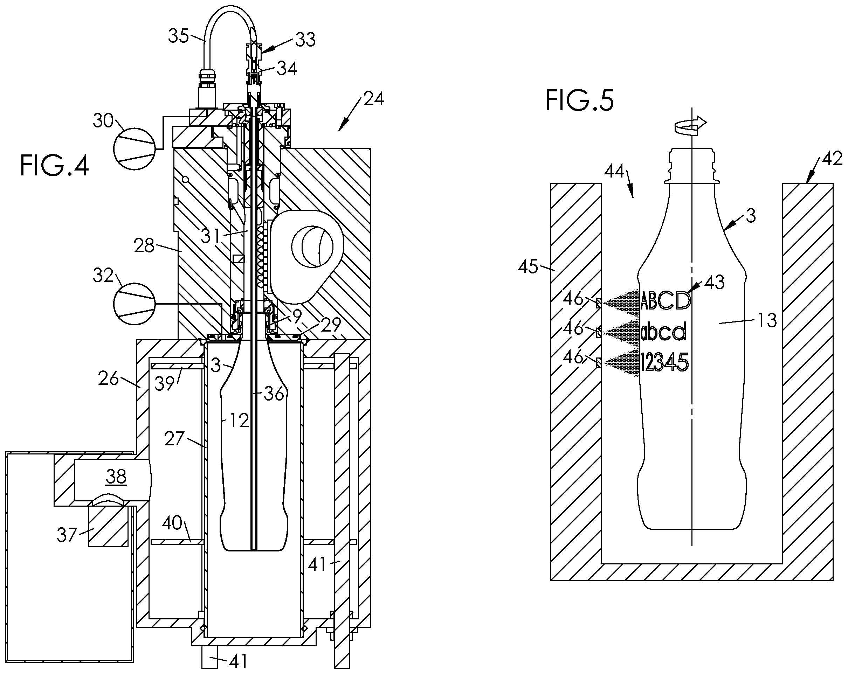

Comme illustré sur la figure 4, chaque poste **24** de traitement comporte une cavité **26** externe de forme avantageusement cylindrique, réalisée dans un matériau conducteur, par exemple métallique (typiquement en acier ou, de préférence, en aluminium ou dans un alliage d'aluminium), et dimensionnée pour permettre l'établissement en son sein d'une onde électromagnétique stationnaire à une fréquence de résonance prédéterminée dans le domaine des micro-ondes, et plus précisément proche de 2 450 MHz (ou 2,45 GHz).

Chaque poste **24** de traitement comprend en outre une enceinte **27** tubulaire, montée de manière coaxiale et étanche dans la cavité **26** et réalisée dans un matériau (par ex. du quartz) transparent au moins aux micro-ondes.

Selon un mode de réalisation particulier, illustré sur la figure 4, l'enceinte **27** est, à une extrémité inférieure, emboîtée de manière étanche dans une zone complémentaire formée dans une paroi inférieure de la cavité **26.**

A une extrémité supérieure, l'enceinte **27** est fermée de manière étanche par un couvercle **28** amovible permettant d'introduire un récipient **3** dans l'enceinte **27** pour permettre son traitement plasma, et de l'en retirer à la fin du traitement plasma.

Comme on le voit bien sur la figure 4, chaque poste **24** de traitement est muni d'un support **29** (notamment en forme de fourchette) qui coopère avec le col **9** du récipient **3** pour assurer la suspension de celui-ci dans l'enceinte **27,** et divers joints qui assurent l'étanchéité du volume interne du récipient **3** vis-à-vis de l'enceinte **27.**

Sont ainsi séparés de manière étanche :
- l'intérieur du récipient **3,**
- l'intérieur de l'enceinte **27** à l'extérieur du récipient **3,**
- l'intérieur de la cavité **26** à l'extérieur de l'enceinte **27.**

Chaque poste **24** de traitement comprend en outre :
- un circuit primaire de vide comprenant une pompe **30** à vide primaire permettant de réaliser un vide poussé (de l'ordre de quelques microbars - 1 microbar = 10⁻⁶ bar) dans le récipient **3,** via une tuyère **31** formée dans le couvercle **28** et débouchant dans le récipient **3** (lorsque celui-ci est présent), et
- un circuit secondaire de vide comprend une pompe **32** à vide secondaire permettant de faire un vide moyen (de l'ordre de quelques millibars) dans l'enceinte **27** à l'extérieur du récipient **3,** pour éviter que celui-ci ne se contracte sous l'effet de la différence de pression de part et d'autre de sa paroi **10** latérale.

Chaque poste **24** de traitement plasma comprend également un dispositif **33** d'injection, dans le récipient **3,** d'un gaz précurseur tel que de l'acétylène (de formule C₂H₂). Comme on le voit sur la figure 4, ce dispositif **33** comprend un injecteur **34** relié, via un flexible **35,** à une source (non représentée) de gaz précurseur, et un tube **36** d'injection branché sur l'injecteur **34** pour acheminer le gaz précurseur dans le récipient **3.**

Pour plus de détail concernant la structure du poste **24** de traitement, l'homme du métier pourra se référer à la description de la demande de brevet US 2010/0206232.

Chaque poste **24** de traitement plasma comprend en outre un générateur **37** d'ondes électromagnétiques dans le domaine des micro-ondes, et plus précisément, ici, au voisinage de 2 450 MHz (ou 2,45 GHz). Selon un mode de réalisation illustré sur la figure 4, le générateur **37** est un magnétron, et il est couplé à la cavité **26** au moyen d'un guide **38** d'onde qui débouche latéralement dans la cavité **26.**

Comme on le voit par ailleurs sur la figure 4, le poste **24** de traitement comprend également une paire de plateaux annulaires superposés, à savoir un plateau **39** supérieur et un plateau **40** inférieur qui sont disposés dans la cavité **26** autour de l'enceinte **27** en étant décalés verticalement de manière à être situés de part et d'autre du guide **38** d'onde. Les plateaux **39, 40** sont réalisés dans un matériau électriquement conducteur (par ex. en acier ou en aluminium) et ont pour fonction de confiner le champ électromagnétique dans la zone où se trouve le récipient **3.** Les plateaux **39, 40** sont fixés sur des tiges **41** qui s'étendent verticalement au travers de la cavité **26** et permettent un réglage de la position des plateaux **39, 40,** de façon à permettre le traitement de récipients **3** de tailles variées. A cet effet, l'une au moins des tiges **40** peut être filetée en étant en prise hélicoïdale avec un taraudage ménagé dans l'un au moins des plateaux **39, 40.** La rotation de la tige filetée permet ainsi de régler la position verticale du (des) plateau(x) **39, 40.**

L'installation **1** comprend, en quatrième lieu, une unité **42** d'impression placée en aval de (et par ex. de manière adjacente à) l'unité **23** de traitement plasma.

Cette unité **42** d'impression est agencée pour imprimer une inscription **43** (informative et/ou décorative) directement sur la face **13** externe des récipients **3.** Selon un mode de réalisation illustré sur les figures 1 et 5, l'unité **42** d'impression comprend un tunnel **44** au sein duquel défilent les récipients **3.** Sur au moins un côté du tunnel **44,** l'unité **42** d'impression comprend une paroi **45** équipée d'une (ou plusieurs, comme dans l'exemple illustré sur la figure 3) tête(s) **46** d'impression agencée(s) pour appliquer une (ou plusieurs) encre(s) sur la face **13** externe des récipients **3.**

L'encre (les encres) peut (peuvent) être à l'état liquide ou à l'état solide. Elle(s) est (sont) par exemple stockée(s) dans un réservoir ou un tonner relié à la (aux) tête(s) **46** d'impression de manière classique par un système d'alimentation. Si l'inscription **43** doit être réalisée en polychromie, il est avantageux de prévoir plusieurs encres de couleurs différentes (typiquement noir, cyan, jaune, magenta) dont le mélange (ou la superposition) permet de réaliser la majorité des teintes et contrastes. L'unité **42** d'impression peut employer la technique du jet d'encre (notamment par un procédé piézo-électrique ou par un procédé thermique), la (ou chaque) tête **46** d'impression étant agencée pour pulvériser l'encre sous forme de fines gouttelettes qui se déposent sur la face externe du récipient pour y former l'inscription **43,** comme schématisé sur la figure 5. En variante, l'unité d'impression peut employer la technique du laser.

Pour permettre une extension de l'inscription **43** sur une partie non négligeable de (et par exemple sur toute) la circonférence du récipient **3,** il est préférable d'entraîner celui-ci en rotation en regard de la (des) tête(s) **46** d'impression, comme illustré par la flèche sur la figure 5. Cette rotation peut être assurée par une tournette, d'une manière similaire à celle des préformes **4** dans l'unité **14** de conditionnement thermique.

En variante, si une partie seulement (par exemple une facette plane) du récipient **3** doit être imprimée, il n'est pas nécessaire d'entraîner le récipient **3** en rotation ; il peut cependant être entraîné en translation pour défiler devant la (les) tête(s) d'impression.

La fabrication d'un emballage **2** à partir d'une préforme **4** est réalisée comme suit.

La préforme **4,** stockée préalablement dans une trémie ou issue directement de sa fabrication par injection plastique, est introduite dans l'unité **14** de conditionnement thermique où elle subit une chauffe qui l'amène à une température supérieure à la température de transition vitreuse de sa matière.

A la sortie de l'unité **14** de conditionnement thermique, la préforme **4** chaude est transférée vers l'unité **19** de formage où est réalisée, dans le moule **21,** une opération de formage du récipient **3** par soufflage ou étirage soufflage à partir de la préforme **4.** Plus précisément, la préforme **4** est placée dans un moule **21** initialement en position ouverte, au moyen d'une pince de préhension. Au fur et à mesure de la rotation de l'unité **19** de formage, le moule **21** est refermé et un fluide (typiquement de l'air) sous pression est injecté dans la préforme **4,** ce qui provoque son gonflement jusqu'à ce que la paroi du moule **21** soit atteinte, conférant ainsi à la préforme **4** l'empreinte du récipient **3.** Puis le moule **21** s'ouvre à nouveau et le récipient **3** formé est éjecté du moule **21** en étant pris en charge par un dispositif de transfert (tel qu'une roue munie de pinces de préhension).

A l'issue de l'unité **19** de formage, le récipient **3** formé éjecté de son moule **21** est transféré vers l'unité **23** de traitement plasma où est réalisée, dans un poste **24** de traitement plasma, une opération de traitement de la face **12** interne du récipient **3,** lors de laquelle une couche barrière mince est formée sur la face **12** interne par dépôt chimique en phase vapeur assisté par plasma.

Plus précisément, le récipient **3** issu de l'unité **19** de formage est, au moyen du support **29,** suspendu dans l'enceinte **27.** L'étanchéité est réalisée, d'une part au niveau du col **9** du récipient **3** entre l'intérieur et l'extérieur de celui-ci (c'est-à-dire dans l'enceinte), et d'autre part entre l'enceinte **27** et la cavité **26.**

Une dépression interne est réalisée dans le récipient **3** au moyen de la pompe **30** à vide primaire via la tuyère **31,** la pression résiduelle dans le récipient **3** étant de quelques microbars.

Une dépression est également réalisée dans l'enceinte **27** à l'extérieur du récipient **3** au moyen de la pompe **32** à vide secondaire, de façon à éviter un écrasement de celui-ci sous la différence de pression de part et d'autre de sa paroi **10** latérale.

Le gaz précurseur est alors injecté dans le récipient **3** au moyen de l'injecteur **34.** La pompe **30** à vide primaire est maintenue ouverte pour permettre le renouvellement du gaz précurseur dans le récipient **3** au cours du traitement.

Le générateur **37** est activé. La propagation des micro-ondes dans la cavité **26** produit une superposition d'ondes incidentes et réfléchies, et l'établissement dans la cavité **26,** pour certaines fréquences, d'un champ électrique micro-ondes stationnaire, dont la distribution spatiale présente, dans la zone du récipient **3,** une concentration locale d'énergie qui permet l'amorçage d'un plasma dans le gaz précurseur.

Le plasma résulte de la décomposition moléculaire du gaz précurseur par l'énergie micro-ondes concentrée au cœur du récipient **3.** Cette décomposition moléculaire du gaz précurseur (en l'espèce de l'acétylène) produit une soupe d'espèces volatiles variées de type CₓH_{y}, où x et y sont des réels avec x≥0 et y≥0, dont une partie au moins est ionique.

Une partie au moins de ces espèces CₓH_{y} se dépose sur la face **12** interne du récipient **3,** contribuant ainsi à la génération d'une couche mince de carbone amorphe hydrogéné a-C:H. Ce type de matériau apparaît au centre du diagramme ternaire d'équilibre carbone-hydrogène, tel qu'illustré notamment dans l'Encyclopédie Ullmann de l'industrie chimique, 5e éd., Vol. A26, p.720.

La dépression interne, la dépression externe, l'injection de gaz précurseur et l'onde électromagnétique sont maintenues, pour entretenir le plasma, pendant une durée de traitement prédéterminée comprise entre 1s et 5s, la couche présentant in fine une épaisseur comprise entre 0,050 µm et 0,200 µm.

Le traitement terminé, le plasma est éteint (par coupure du générateur **37** et/ou par coupure de l'injection du gaz précurseur) et le récipient **3** traité (c'est-à-dire pourvu de sa couche barrière) est évacué de l'unité **23** de traitement plasma et transféré vers l'unité **42** d'impression, au moyen d'un dispositif de transfert tel qu'une roue pourvue de pinces de préhension.

Dans l'unité **42** d'impression est réalisée une opération d'impression de la face **13** externe du récipient **3,** au cours de laquelle l'encre est déposée sur la face **13** externe pour y former l'inscription **43.**

La couche mince formée dans l'unité **23** de traitement plasma sur la face **12** interne du récipient **3** forme un obstacle à la migration de composés de l'encre (ou des encres) vers l'intérieur du récipient **3,** ce qui permet de préserver son contenu (c'est-à-dire le produit **5**) de toute contamination chimique, et donc de préserver les propriétés organoleptiques de celui-ci ainsi que la santé du consommateur.

Cette barrière ainsi constituée, il est possible de recourir à des encres et à des solvants qui, bien que non alimentaires, présentent par ailleurs de bonnes propriétés physico-chimiques (notamment une bonne adhérence sur la face externe du récipient, une bonne vivacité des couleurs et un bon contraste, au bénéfice de la lisibilité de l'inscription **43**).

Chaque récipient **3** imprimé est, à la sortie de l'unité **42** d'impression, transféré vers une unité **47** de remplissage au sein de laquelle un produit **5** (pulvérulent, liquide ou pâteux) est versé dans le récipient **3** (figure 6).

Le récipient **3** rempli est alors transféré vers une **48** unité de bouchage (cf. figure 7 - l'unité **47** de remplissage et l'unité **48** de bouchage peuvent former une seule et même machine pourvue d'un unique carrousel, comme cela est fréquent) au sein de laquelle un bouchon **6** est rapporté et vissé sur le col **9** pour réaliser la fermeture étanche du récipient **3,** ce qui achève la production de l'emballage **2** (figure 8). Celui-ci peut alors subir un conditionnement supplémentaire, plusieurs emballages étant par exemple regroupés pour former un pack, lequel peut être cartonné et/ou filmé, puis, le cas échéant, palettisé pour faciliter sa manutention et son transport vers des zones de distribution.

De manière alternative, il est envisageable de procéder à l'impression du récipient **3** après son remplissage (et son bouchage). Cependant, le produit étant susceptible de contaminer la face **13** externe du récipient **3,** et donc d'altérer l'application de l'encre (ou des encres), il est préférable de procéder à l'impression avant de procéder au remplissage.

## Revendications

1. Procédé de fabrication d'un emballage **(2)** comprenant un récipient **(3),** ce procédé comprenant :
- une opération de formage du récipient **(3)** par soufflage ou étirage soufflage à partir d'une préforme **(4)** en matière plastique ;
- une opération de traitement d'une face **(12)** interne du récipient **(3),** lors de laquelle une couche barrière mince est formée sur la face **(12)** interne par dépôt chimique en phase vapeur assisté par plasma,
ce procédé étant **caractérisé en ce qu'**il comprend une opération d'impression d'une face **(13)** externe du récipient **(3),** lors de laquelle une encre est déposée sur la face **(13)** externe pour y former une inscription **(43)** décorative et/ou informative,
et **en ce que** l'impression est réalisée par jet d'encre.

2. Procédé de fabrication selon la revendication 1, **caractérisé en ce que** l'opération de traitement d'une face **(12)** interne du récipient **(3)** a lieu entre l'opération de formage et l'opération d'impression.

3. Procédé de fabrication selon la revendication 1 ou 2, **caractérisé en ce que** la couche barrière comprend du carbone amorphe hydrogéné.

4. Procédé de fabrication selon l'une des revendications précédentes, **caractérisé en ce que** l'impression est réalisée par pulvérisation.

5. Procédé de fabrication selon l'une des revendications précédentes, **caractérisé en ce que**, au cours de l'opération d'impression, le récipient (3) est entraîné en rotation.

6. Procédé de fabrication selon l'une des revendications précédentes, **caractérisé en ce qu'**il comprend, préalablement à l'opération de formage du récipient (3), une opération de conditionnement thermique de la préforme (4).

7. Installation (1) pour la fabrication d'emballage comprenant chacun un récipient, cette installation (1) comprenant :
- une unité **(19)** de formage des récipients **(3)** à partir de préformes **(4)** en matière plastique ;
- une unité (23) de traitement d'une face (12) interne des récipients (3), apte à y former une couche barrière mince par dépôt chimique en phase vapeur assisté par plasma,
**caractérisée en ce qu'**elle comprend une unité (42) d'impression d'une face (13) externe des récipients (3) ;
et **en ce que** l'impression est réalisée par jet d'encre.

8. Installation (1) selon la revendication 7, **caractérisée en ce que** l'unité (23) de traitement est interposée entre l'unité (19) de formage et l'unité (42) d'impression.

9. Installation (1) selon la revendication 8, **caractérisée en ce que** l'unité (23) de traitement est adjacente à l'unité (19) de formage.

10. Installation (1) selon la revendication 8 ou la revendication 9, **caractérisée en ce que** l'unité (23) de traitement est adjacente à l'unité (42) d'impression.

11. Installation (1) selon l'une des revendications 8 à 10, **caractérisée en ce qu'**elle comprend en outre une unité (14) de conditionnement thermique des préformes (4).

## Patentansprüche

1. Verfahren zur Herstellung einer Verpackung (2), die einen Behälter (3) umfasst, wobei dieses Verfahren umfasst:
- einen Vorgang des Formens des Behälters (3) durch Blasen oder Streckblasen ausgehend von einem Vorformling (4) aus Kunststoff;
- einen Vorgang des Behandelns einer Innenseite (12) des Behälters (3), bei dem eine dünne Barriereschicht auf der Innenseite (12) durch plasmagestützte chemische Gasphasenabscheidung gebildet wird,
wobei das Verfahren **dadurch gekennzeichnet ist, dass** es einen Vorgang des Bedruckens einer Außenseite (13) des Behälters (3) umfasst, bei dem eine Druckfarbe auf der Außenseite (13) abgeschieden wird, um darauf eine dekorative und/oder informative Beschriftung (43) zu bilden,
und dass das Drucken mit Tintenstrahl ausgeführt wird.

2. Herstellungsverfahren nach Anspruch 1, **dadurch gekennzeichnet, dass** der Vorgang des Behandelns einer Innenseite (12) des Behälters (3) zwischen dem Formvorgang und dem Druckvorgang stattfindet.

3. Herstellungsverfahren nach Anspruch 1 oder 2, **dadurch gekennzeichnet, dass** die Barriereschicht amorphen hydrogenierten Kohlenstoff umfasst.

4. Herstellungsverfahren nach einem der vorhergehenden Ansprüche, **dadurch gekennzeichnet, dass** das Drucken durch Sprühen ausgeführt wird.

5. Herstellungsverfahren nach einem der vorhergehenden Ansprüche, **dadurch gekennzeichnet, dass** der Behälter (3) während des Druckvorgangs drehangetrieben wird.

6. Herstellungsverfahren nach einem der vorhergehenden Ansprüche, **dadurch gekennzeichnet, dass** es vor dem Vorgang des Formens des Behälters (3) einen Vorgang des Temperierens des Vorformlings (4) umfasst.

7. Anlage (1) zur Herstellung von Verpackungen, die jeweils einen Behälter umfassen, wobei diese Anlage (1) umfasst:
- eine Formeinheit (19) zum Formen der Behälter (3) ausgehend von Vorformlingen (4) aus Kunststoff;
- eine Behandlungseinheit (23) zum Behandeln einer Innenseite (12) der Behälter (3), die geeignet ist, darauf durch plasmagestützte chemische Gasphasenabscheidung eine dünne Barriereschicht zu bilden,
**dadurch gekennzeichnet, dass** sie eine Einheit (42) zum Bedrucken einer Außenseite (13) der Behälter (3) umfasst;
und dass das Drucken mit Tintenstrahl ausgeführt wird.

8. Anlage (1) nach Anspruch 7, **dadurch gekennzeichnet, dass** die Behandlungseinheit (23) zwischen der Formeinheit (19) und der Druckeinheit (42) angeordnet ist.

9. Anlage (1) nach Anspruch 8, **dadurch gekennzeichnet, dass** die Behandlungseinheit (23) zur Formeinheit (19) benachbart ist.

10. Anlage (1) nach Anspruch 8 oder Anspruch 9, **dadurch gekennzeichnet, dass** die Behandlungseinheit (23) zur Druckeinheit (42) benachbart ist.

11. Anlage (1) nach einem der Ansprüche 8 bis 10, **dadurch gekennzeichnet, dass** sie ferner eine Temperierungseinheit (14) zur Temperierung der Vorformlinge (4) umfasst.

## Claims

1. Process for manufacturing a packaging **(2)** comprising a container **(3),** this process comprising:
- an operation for forming the container **(3)** by blow moulding or stretch blow moulding starting from a plastic preform **(4);**
- an operation for treating an inner face **(12)** of the container **(3),** during which a thin barrier layer is formed on the inner face **(12)** by plasma-enhanced chemical vapour deposition,
this process being **characterized in that** it comprises an operation for printing an outer face **(13)** of the container **(3),** during which an ink is deposited on the outer face **(13)** in order to form thereon a decorative and/or informative inscription **(43),**
and **in that** the printing is carried out by inkjet.

2. Manufacturing process according to Claim 1, **characterized in that** the operation for treating an inner face **(12)** of the container **(3)** takes place between the forming operation and the printing operation.

3. Manufacturing process according to Claim 1 or Claim 2, **characterized in that** the barrier layer comprises hydrogenated amorphous carbon.

4. Manufacturing process according to one of the preceding claims, **characterized in that** the printing is carried out by spraying.

5. Manufacturing process according to one of the preceding claims, **characterized in that**, during the printing operation, the container **(3)** is rotated.

6. Manufacturing process according to one of the preceding claims, **characterized in that** it comprises, prior to the operation for forming the container **(3),** an operation for thermal conditioning of the preform (4).

7. Equipment **(1)** for the manufacture of packaging each comprising a container, this equipment **(1)** comprising:
- a unit **(19)** for forming containers **(3)** from plastic preforms **(4);**
- a unit **(23)** for treating an inner face **(12)** of the containers **(3),** capable of forming thereon a thin barrier layer by plasma-enhanced chemical vapour deposition,
**characterized in that** it comprises a unit **(42)** for printing an outer face **(13)** of the containers **(3);**
and **in that** the printing is carried out by inkjet.

8. Equipment **(1)** according to Claim 7, **characterized in that** the treatment unit **(23)** is interposed between the forming unit **(19)** and the printing unit **(42).**

9. Equipment **(1)** according to Claim 8, **characterized in that** the treatment unit **(23)** is adjacent to the forming unit **(19).**

10. Equipment **(1)** according to Claim 8 or Claim 9, **characterized in that** the treatment unit **(23)** is adjacent to the printing unit **(42).**

11. Equipment **(1)** according to one of Claims 8 to 10, **characterized in that** it further comprises a unit **(14)** for thermal conditioning of the preforms **(4).**
